# DEMANDE DE BREVET EUROPEEN

(11) **EP 1 670 066 A1**
(43) Date de publication de la demande: **14.06.2006**
(21) Numéro de dépôt: 05111800.8
(22) Date de dépôt: 07.12.2005
(51) Int. Cl.: H01L 31/18, H01L 31/108, H01L 31/105

(54) **Procédé de fabrication d'un circuit intégré comprenant un miroir enterré et ce circuit**

(30) Priorité: 08.12.2004 FR 0452900
(71) Demandeur: ST MICROELECTRONICS S.A., 92120 Montrouge (FR); STMICROELECTRONICS (CANADA), INC., Nepean ON (CA)
(72) Inventeur: Jouan, Sébastien, 38920, Crolles (FR); Marty, Michel, 38760 Saint Paul de Varces (FR)
(74) Mandataire: de Beaumont, Michel

(57) **Abrégé**

L'invention concerne un procédé de réalisation d'un miroir enterré dans un composant semiconducteur comprenant les étapes suivantes : former une structure comprenant une couche semiconductrice posée sur une couche isolante recouvrant un substrat ; former une ou plusieurs ouvertures dans la couche semiconductrice débouchant en surface de la couche isolante ; éliminer une portion de la couche isolante, d'où il résulte qu'un évidement est formé ; former une seconde couche isolante mince contre la paroi de l'évidement ; et former une couche métallique dans l'évidement contre la seconde couche isolante.

## Description

### Domaine de l'invention

La présente invention concerne un miroir enterré sous une zone semiconductrice active d'un composant semiconducteur tel qu'une photodiode.

### Exposé de l'art antérieur

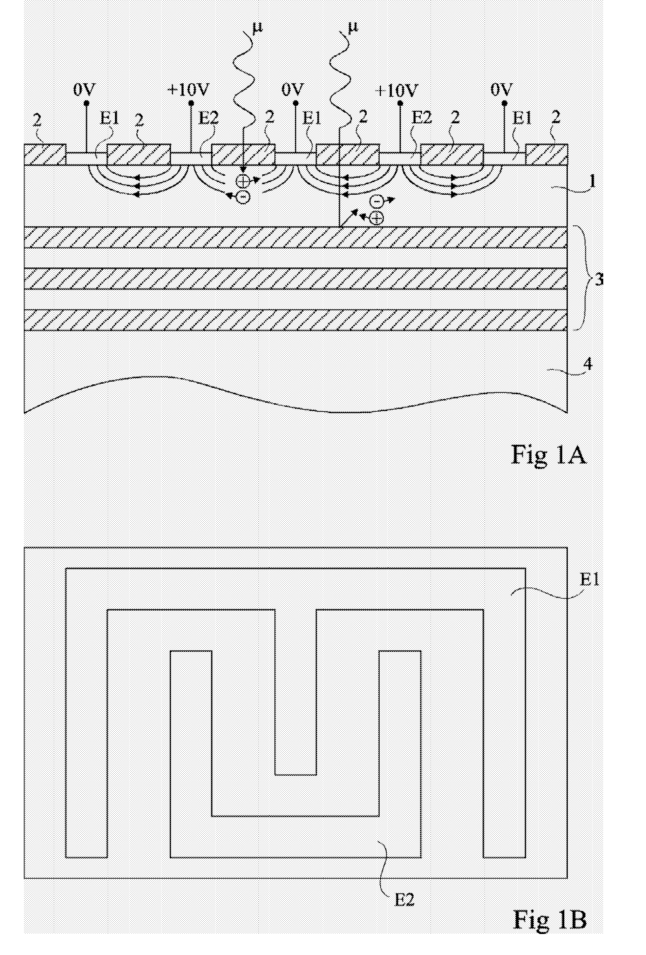

Les figures 1A et 1B sont respectivement une vue en coupe et une vue de dessus d'une photodiode de type métal-semiconducteur-métal MSM telle que décrite dans le brevet US 5525828. La photodiode comprend une zone semiconductrice active 1 sur laquelle sont formées deux électrodes métalliques E1 et E2 ayant de préférence une structure interdigitée. Les électrodes E1 et E2 sont séparées par une zone isolante 2. Cette photodiode comprend un élément réfléchissant 3 tel qu'un miroir de Bragg placé sous la zone active 1 au-dessus d'un substrat 4. Un exemple de miroir de Bragg est un empilement de couches d'oxyde de silicium et de couches de nitrure de silicium alternées.

Chaque électrode E1 et E2 correspond à l'anode d'une diode Schottky constituée d'une électrode E1 ou E2 et de la zone semiconductrice 1. La photodiode est donc équivalente à deux diodes Schottky tête-bêche.

Une tension est appliquée entre les électrodes E1 et E2. Dans cet exemple, l'électrode E1 est à la masse et l'électrode E2 à une tension positive égale à 10 volts. Les diodes Schottky ayant pour anode l'électrode E1 sont polarisées en inverse. En conséquence, une zone de charge d'espace se forme sous la zone isolante 2 entre les électrodes E1 et E2. Le champ électrique induit par cette zone de charge d'espace est représenté sur la figure 1A par un ensemble de courbes fléchées allant de l'électrode E2 à 10 V vers l'électrode E1 à la masse.

La zone isolante 2 est transparente de façon à laisser passer les photons d'un faisceau lumineux incident. Ces photons sont absorbés par la zone active semiconductrice 1 et des paires "électron-trou" se créent. Les électrons et les trous sont accélérés par le champ électrique présent dans la zone de charge d'espace, puis collectés par une des électrodes E1 et E2. Un courant électrique se crée entre l'électrode E2 et l'électrode E1.

Les photons n'ayant pas été absorbés par la zone active avant d'arriver au niveau du miroir réfléchissant 3 sont réfléchis vers la surface de la zone active 1. Ces photons peuvent alors être absorbés lors de leur remontée. La profondeur maximale de pénétration d'un photon dans du silicium étant relativement élevée, environ 17 microns, l'utilisation d'un miroir réfléchissant 3 permet de "concentrer" les photons à proximité des électrodes E1 et E2 où le champ électrique est élevé. Ceci permet d'avoir des photodiodes plus sensibles et présentant une fréquence de fonctionnement plus élevée.

L'utilisation de miroirs de Bragg nécessite néanmoins de mettre en oeuvre des procédés de fabrication complexes. Un des procédés connus consiste à former un empilement de couches d'oxyde de silicium et de nitrure sur un substrat support puis à venir coller une plaque de silicium sur cet empilement et à raboter ensuite la plaque de silicium jusqu'à obtenir une zone active ayant une épaisseur de quelques centaines de nanomètres. De plus, pour qu'un miroir de Bragg soit réfléchissant, il faut prévoir des épaisseurs très précises d'oxyde de silicium et de nitrure ce qui ne facilite pas leur fabrication. De plus, le miroir de Bragg est réfléchissant pour une unique valeur de longueur d'onde.

Un objet de la présente invention est de prévoir un composant semiconducteur comprenant un miroir qui soit réfléchissant sur une grande plage de valeurs de longueurs d'onde.

Un autre objet de la présente invention est de prévoir un procédé de fabrication d'un tel composant.

Un autre objet de la présente invention est de prévoir une structure de photodiode très sensible et présentant un temps de réponse court.

### Résumé de l'invention

Pour atteindre ces objets, la présente invention prévoit un procédé de réalisation d'un miroir enterré dans un composant semiconducteur comprenant les étapes suivantes : former une structure comprenant une couche semiconductrice posée sur une couche isolante recouvrant un substrat ; former une ou plusieurs ouvertures dans la couche semiconductrice débouchant en surface de la couche isolante ; éliminer une portion de la couche isolante, d'où il résulte qu'un évidement est formé ; former une seconde couche isolante mince contre la paroi de l'évidement ; et former une couche métallique dans l'évidement contre la seconde couche isolante.

Dans un mode de mise en oeuvre du procédé précédemment décrit, la seconde couche isolante mince a une épaisseur inférieure au quart de la longueur d'onde de la lumière susceptible d'être réfléchie par le miroir.

Dans un mode de mise en oeuvre du procédé précédemment décrit, le procédé comprend, préalablement à la formation des ouvertures, les étapes suivantes : graver la couche semiconductrice, la couche isolante et la partie supérieure du substrat de façon à former une tranchée entourant ladite portion de la couche isolante ; et remplir la tranchée précédemment formée d'un matériau différent de ladite portion.

Dans un mode de mise en oeuvre du procédé précédemment décrit, le substrat et la couche semiconductrice sont constitués de silicium monocristallin, la couche isolante étant constituée d'oxyde de silicium.

Dans un mode de mise en oeuvre du procédé précédemment décrit, la couche métallique est en aluminium.

La présente invention prévoit aussi un circuit intégré formé dans une plaque de type SOI constituée d'une couche de silicium placée sur une couche d'oxyde de silicium recouvrant un substrat de silicium, et incluant un composant semiconducteur comprenant un miroir enterré placé sous une zone active semiconductrice, une portion de la couche d'oxyde de silicium étant remplacée par ledit miroir constitué d'une couche métallique recouverte d'une couche isolante, la portion de la couche de silicium située au-dessus de la couche métallique constituant ladite zone active du composant.

Selon une variante du circuit susmentionné, le composant est de type photodiode, des photons étant susceptibles de créer des paires électron-trou dans ladite zone active.

Selon une variante du circuit susmentionné, le composant est une photodiode de type MSM, des électrodes métalliques étant placées au-dessus de la zone active.
Selon une variante du circuit susmentionné, le composant est une photodiode latérale, des zones dopées de type P et N séparées par une zone non dopée intrinsèque I étant formées dans ladite zone active.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A et 1B sont respectivement une vue en coupe et une vue de dessus, précédemment décrites, d'une photodiode MSM connue ;
la figure 2 est une vue en coupe d'une photodiode de type MSM selon un mode de réalisation de la présente invention ;
les figures 3A à 3E sont des vues en coupe, et la figure 3F une vue en perspective, illustrant des structures obtenues après des étapes successives d'un mode de mise en oeuvre du procédé de la présente invention ;
la figure 4 est une vue en coupe d'une photodiode latérale selon un autre mode de réalisation de la présente invention ; et
la figure 5 est une vue en coupe d'un guide d'onde selon un autre mode de réalisation de la présente invention.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

La présente invention prévoit de former un composant semiconducteur tel qu'une photodiode comprenant sous une zone semiconductrice active, une couche métallique constituant un miroir. La présente invention prévoit aussi un procédé pour réaliser un tel miroir.

La demande de brevet FR 0212278 décrit un circuit intégré comprenant une couche métallique enterrée utilisée pour augmenter la conductivité d'une zone semiconductrice du circuit. Cette couche métallique est constituée d'un matériau fortement conducteur tel que du cuivre, un siliciure métallique, un nitrure de titane ou même du silicium polycristallin dopé. Quel que soit le matériau utilisé, la couche métallique en contact avec la zone semiconductrice tend à réagir avec cette dernière pour former une couche de "transition" généralement une couche de siliciure constituée de gros grains. La surface d'interface entre la couche métallique enterrée et la zone semiconductrice est donc rugueuse et ne constitue pas un miroir susceptible de réfléchir un faisceau lumineux dans une direction souhaitée. C'est une surface diffusante.

Un composant selon la présente invention comprend à contrario une couche métallique enterrée présentant une surface "lisse" présentant un coefficient de réflexion maximal et un coefficient de diffusion négligeable.

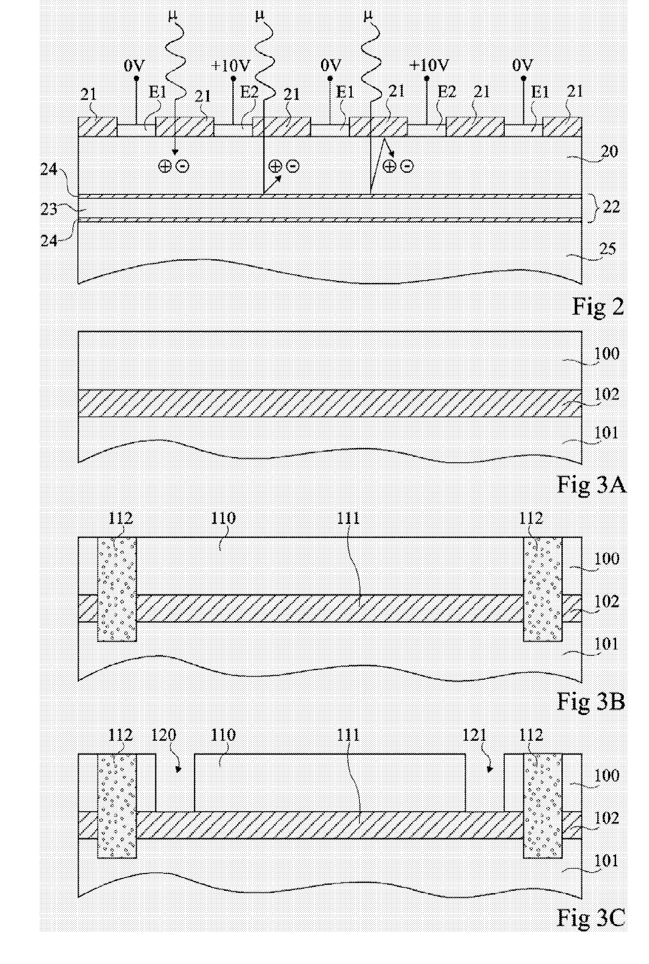

La figure 2 est une vue en coupe d'une photodiode de type MSM selon un mode de réalisation de la présente invention. La photodiode comprend une zone active semiconductrice 20 sur laquelle sont placées des électrodes métalliques E1 et E2. Une couche isolante transparente 21 sépare les électrodes E1 et E2.

Selon un aspect de la présente invention, un miroir 22 comprenant une couche métallique 23 recouverte d'une couche isolante 24 est placé sous la zone active 20, au-dessus d'une couche support 25. Les portions de la couche isolante 24 situées au-dessus et au-dessous de la couche métallique 23 sont visibles dans cette vue en coupe. La couche isolante 24 est très mince, par exemple d'une épaisseur inférieure à 20 nm, c'est-à-dire nettement inférieure au quart de la longueur d'onde de la lumière que le miroir est susceptible de réfléchir. Ainsi la couche isolante 24 n'est pas susceptible de créer des phénomènes d'interférences et n'influe pas sur les phénomènes de réflexion.

Comme expliqué précédemment, les électrodes E1 et E2 sont reliées à des potentiels différents. Une zone de charge d'espace se forme sous la couche isolante 21 et un champ électrique se crée entre les deux électrodes E1 et E2. Un courant électrique se crée entre les électrodes E1 et E2 lorsque des photons d'un faisceau lumineux incident sont absorbés par la zone active 20.

Les photons incidents ayant traversé la zone active 20 sans être absorbés par celle-ci sont réfléchis par le miroir 22, et plus particulièrement par la couche métallique 23, et repassent à travers la zone active 20. Une partie de ces photons réfléchis est alors absorbée par la zone active lors de leur remontée. Les photons arrivant à l'interface entre la zone active et la couche isolante 21 sans être absorbés sont pour partie réfléchis vers la zone active 20.

L'épaisseur de la couche métallique est suffisante pour que cette couche soit totalement réfléchissante. Une épaisseur de quelques dizaines de nanomètres permet d'avoir un miroir totalement réfléchissant pour des faisceaux lumineux couramment utilisés dans le domaine visible, infrarouge ou ultraviolet.

Une photodiode selon la présente invention peut être obtenue selon un mode de mise en oeuvre du procédé de la présente invention décrit ci-après en relation avec les figures 3A à 3F.

Dans une étape initiale, illustrée en figure 3A, on forme une structure "semiconducteur-isolant-substrat" comprenant une couche semiconductrice 100 posée sur un substrat 101 recouvert d'une couche isolante 102. Cette structure est par exemple une plaque de type silicium sur isolant, ou SOI de l'anglais Silicon On Insulator pouvant être obtenue selon divers procédés connus. Quel que soit le procédé, l'interface entre la couche semiconductrice 100 et la couche isolante 102 présente une excellente planéité.

Dans une étape suivante, illustrée en figure 3B, on grave la couche semiconductrice 100, puis la couche isolante 102 et enfin le substrat 101 de façon à former une tranchée annulaire traversant les couches 100 et 102 et pénétrant en surface du substrat 101. La tranchée est ensuite remplie d'un matériau différent de celui de la couche isolante 102 afin de former un mur annulaire 112 entourant une portion 110 de la couche semiconductrice 100 et une portion 111 de la couche isolante 102. Le mur 112 est par exemple constitué de silicium polycristallin. Dans cet exemple, le mur est sensiblement rectangulaire en vue dessus. Deux portions sont visibles sur la gauche et la droite de la structure représentée.

A l'étape suivante, illustrée en figure 3C, on grave la couche semiconductrice 100 jusqu'à atteindre la couche isolante 102 de façon à former une ou plusieurs ouvertures dans la portion semiconductrice 110 entourée par le mur 112. Dans cet exemple, deux ouvertures 120 et 121 ayant la forme de tranchées sensiblement parallèles sont formées à proximité des deux portions représentées du mur annulaire 112.

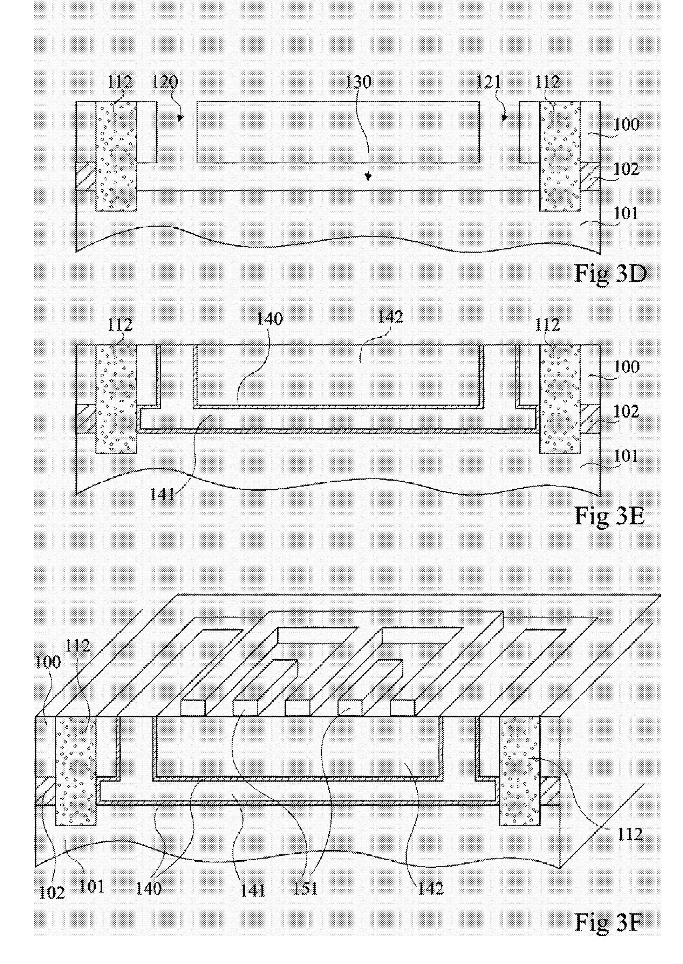

A l'étape suivante, illustrée en figure 3D, on grave la portion isolante 111 située à l'intérieur du mur 112. L'élimination de la portion isolante 111 peut être effectuée selon un procédé classique de gravure humide, la portion étant éliminée progressivement à partir des ouvertures 120 et 121. A l'issue de cette étape, on obtient un évidement 130 débouchant en surface de la couche semiconductrice 100 par l'intermédiaire des ouvertures 120 et 121. On choisit de préférence un procédé de gravure très sélectif ne gravant pas la couche semiconductrice afin de conserver la planéité de la surface inférieure de la couche semiconductrice au niveau de la paroi de l'évidement 130.

A l'étape suivante, illustrée en figure 3E, on dépose une couche de protection 140 contre la paroi de l'évidement 130. La couche de protection est par exemple une fine couche d'oxyde de silicium obtenue par oxydation thermique de la couche semiconductrice 100, du substrat 101 et du mur annulaire 113. On remplit ensuite l'évidement 130 et les ouvertures 120 et 121 d'un ou de plusieurs matériaux métalliques. On effectuera par exemple un dépôt de 10 à 30 nm d'un métal tel que l'aluminium selon un procédé de dépôt de couches atomiques, connu sous le nom d'ALD de l'anglais Atomic Layer Deposition, puis un dépôt chimique en phase vapeur d'un matériau tel que du nitrure de silicium afin de "remplir" complètement l'évidement. On obtient alors une couche métallique enterrée 141. La couche métallique 141 constitue un miroir. La portion de la couche semiconductrice 100 située au-dessus de ce miroir constitue une zone active 142.

La couche de protection 140 est prévue pour éviter toute réaction entre la couche semiconductrice et la couche métallique enterrée susceptible de former une couche de transition à gros grains. De plus, la couche de protection doit "conserver" la planéité de la surface inférieure de la couche semiconductrice de façon que la surface d'interface entre la couche de protection et la couche métallique 141 soit aussi lisse que la surface de la couche semiconductrice. En outre, la couche de protection 140 peut avantageusement servir de couche d'accrochage assurant une bonne tenue de la couche métallique.

A l'étape suivante, illustrée en figure 3F, on forme dans et au-dessus de la zone active 142 les éléments correspondants au type de photodiode que l'on souhaite obtenir. Dans cet exemple on forme une photodiode de type métal-semiconducteur-métal. Deux électrodes métalliques interdigitées 150 et 151 sont placées au-dessus de la zone active 141.

Selon une variante du procédé précédemment décrit, les électrodes métalliques interdigitées sont formées préalablement à la formation du miroir enterré, en recouvrant les électrodes d'un matériau de protection.

Dans le cas où la photodiode précédemment formée fait partie d'un circuit intégré comprenant plusieurs composants, il est souhaitable que la zone active 142 soit isolée électriquement du substrat et du reste de la couche semiconductrice 100. Pour ce faire, la couche de protection 140 est constituée d'un matériau isolant tel que l'oxyde de silicium et le mur annulaire 112 est isolant. Le mur annulaire peut être constitué de silicium dopé avec des éléments dopants différents de ceux éventuellement présents dans la zone active 142. Le mur annulaire peut aussi être constitué de silicium polycristallin recouvert d'une couche d'oxyde de silicium. Dans ce dernier cas, préalablement au remplissage des ouvertures traversant la couche semiconductrice 100, la couche isolante 101 et débouchant en surface du substrat 102, avec du silicium polycristallin, on forme une fine couche d'oxyde de silicium contre les parois des ouvertures.

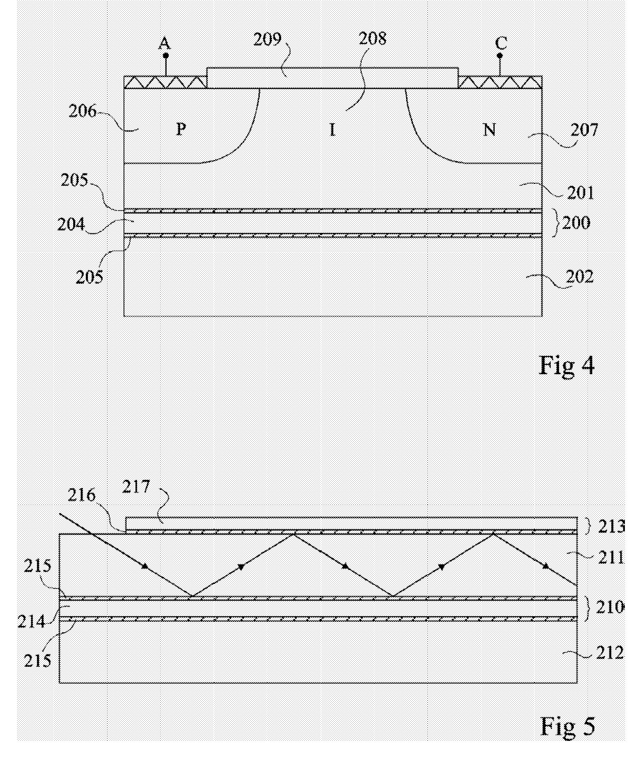

La figure 4 est une vue en coupe d'une photodiode latérale selon un mode de réalisation de la présente invention comprenant un miroir enterré pouvant être obtenu selon le procédé décrit précédemment. La photodiode comprend un miroir 200 placé sous une zone active semiconductrice 201 et au-dessus d'un substrat 202. Le miroir est constitué d'une couche métallique 204 recouverte d'une couche isolante 205. Une zone dopée 206 de type P et une zone dopée 207 de type N séparées par une zone non dopée 208 dite "intrinsèque" I sont formées en surface de la zone active 201. Des métallisations d'anode A et de cathode C recouvrent respectivement les zones 206 et 207. Une couche isolante 209 est placée entre les métallisations d'anode et de cathode au-dessus de la zone intrinsèque 208.

En fonctionnement, la photodiode PIN est polarisée en inverse. Sa cathode est à un potentiel plus élevé que son anode de façon à former une large zone de charge d'espace. Les photons d'un faisceau lumineux incident traversant la couche isolante 209 sont absorbés par le substrat et créent des paires "électron-trou". Les porteurs de chaque paire sont accélérés par le fort champ électrique présent dans la zone de charge d'espace. Les trous se dirigent vers l'anode et les électrons vers la cathode. En conséquence, lorsque la photodiode reçoit un faisceau lumineux, un courant se crée entre cathode et anode.

Le miroir 200 réfléchit les photons incidents qui ont traversé la zone active 201 sans être absorbés. Une partie de ces photons réfléchis est alors absorbée par la zone active lors de leur remontée. Les photons arrivant à l'interface entre la zone active 200 et la couche isolante 208 sans être absorbés sont pour partie réfléchis vers la zone active 201.

La figure 5 est une vue en coupe d'un guide d'onde selon un mode de réalisation de la présente invention. Ce guide d'onde comprend un miroir "enterré" 210 placé sous une zone active semiconductrice 211, au-dessus d'un substrat 212, et un miroir 213 placé sur la zone active 211. Le miroir 210 est constitué d'une couche métallique 214 recouverte d'une couche isolante 215, les portions de la couche isolante 215 situées sous et sur la couche métallique 214 étant visibles dans cette vue en coupe. Le miroir 213 est constitué d'un empilement d'une couche isolante 216 et d'une couche métallique 217.

Un faisceau lumineux incident peut pénétrer dans la zone active 211 par une portion de surface découverte de la zone active. Le faisceau est ensuite réfléchi alternativement par le miroir 210 et le miroir 213 jusqu'à atteindre une sortie du guide d'onde ou un capteur non représentés.

L'homme de l'art pourra imaginer d'autres composants semiconducteurs comprenant une couche métallique comme miroir placé sous une zone active semiconductrice. On pourra par exemple former un démultiplexeur de fréquences d'un faisceau lumineux ayant une structure sensiblement identique à celle du guide d'onde représenté en figure 5 et comprenant une série de zones de filtre placées au-dessus de la zone active 211 dans des ouvertures du miroir 213.

De façon générale, le procédé de fabrication d'un miroir enterré selon la présente invention consiste à former une couche métallique réfléchissante sous une zone active semiconductrice d'un composant semiconducteur formé dans une structure "semiconducteur-isolant-substrat" comprenant une couche semiconductrice posée sur une couche isolante recouvrant un substrat. Le procédé de fabrication du miroir consiste à éliminer une portion de la couche isolante de la structure semiconducteur-isolant-substrat, et à remplir l'évidement ainsi formé d'une couche de protection puis d'une couche métallique.

On forme une couche métallique présentant une surface la plus plane possible de façon à "contrôler" la réflexion. Pour ce faire, on utilise une structure "semiconducteur-isolant-substrat" présentant une surface d'interface entre la couche semiconductrice et la couche isolante qui soit la plus plane possible afin d'obtenir après élimination de la portion isolante un évidement présentant une surface la plus plane possible.

De plus, on choisit de préférence des matériaux de remplissage permettant de "conserver" la planéité de l'évidement et pour éviter toute réaction néfaste entre la couche métallique et la couche semiconductrice, on forme sur les parois de l'évidement une couche de protection ne modifiant pas l'état de surface de l'évidement.

En outre, la couche métallique réfléchissante est formée selon un procédé de dépôt permettant d'obtenir des grains les plus fins possibles afin que la couche métallique réfléchissante ait une surface la plus lisse possible. Le procédé actuellement le plus adapté est un procédé de dépôt de couches atomiques.

L'avantage d'un composant selon la présente invention est qu'il comprend comme miroir une couche métallique qui est réfléchissante quelle que soit la longueur d'onde du faisceau incident.

Bien entendu, la présente invention est susceptible de diverses variantes et modifications qui apparaîtront à l'homme de l'art. En particulier, l'homme de l'art pourra imaginer d'autres composants semiconducteurs selon la présente invention. De plus, l'homme de l'art pourra imaginer d'autres procédés d'élimination d'une portion de la couche isolante de la structure initiale semiconducteur-isolant-substrat.

## Revendications

1. Procédé de réalisation d'un miroir enterré dans un composant semiconducteur comprenant les étapes suivantes :
former une structure comprenant une couche semiconductrice (100) posée sur une couche isolante (102) recouvrant un substrat (101) ;
former une ou plusieurs ouvertures (120, 121) dans la couche semiconductrice débouchant en surface de la couche isolante ;
éliminer une portion de la couche isolante, d'où il résulte qu'un évidement (130) est formé ;
former une seconde couche isolante mince (140) contre la paroi de l'évidement ; et
former une couche métallique (141) dans l'évidement contre la seconde couche isolante.

2. Procédé selon la revendication 1, dans lequel la seconde couche isolante mince (140) a une épaisseur inférieure au quart de la longueur d'onde de la lumière susceptible d'être réfléchie par le miroir.

3. Procédé selon la revendication 1, comprenant, préalablement à la formation des ouvertures (120, 121), les étapes suivantes :
graver la couche semiconductrice (100), la couche isolante (102) et la partie supérieure du substrat (101) de façon à former une tranchée entourant ladite portion (111) de la couche isolante ; et
remplir la tranchée précédemment formée d'un matériau (112) différent de ladite portion.

4. Procédé selon la revendication 1, dans lequel le substrat (101) et la couche semiconductrice (100) sont constitués de silicium monocristallin, la couche isolante (102) étant constituée d'oxyde de silicium.

5. Procédé selon la revendication 1, dans lequel la couche métallique (141) est en aluminium.

6. Circuit intégré formé dans une plaque de type SOI constituée d'une couche de silicium (100) placée sur une couche d'oxyde de silicium (102) recouvrant un substrat de silicium (101), et incluant un composant semiconducteur comprenant un miroir enterré placé sous une zone active semiconductrice, une portion (111) de la couche d'oxyde de silicium étant remplacée par ledit miroir constitué d'une couche métallique (23, 204, 214) recouverte d'une couche isolante (24, 205, 215), la portion (110) de la couche de silicium située au-dessus de la couche métallique constituant ladite zone active (141) du composant.

7. Circuit selon la revendication 6, comprenant un composant de type photodiode, des photons étant susceptibles de créer des paires électron-trou dans ladite zone active (20, 201).

8. Circuit selon la revendication 7, dans lequel le composant est une photodiode de type MSM, des électrodes métalliques (E1, E2) étant placées au-dessus de la zone active (20).

9. Circuit selon la revendication 7, dans lequel le composant est une photodiode latérale, des zones dopées de type P et N (206, 207) séparées par une zone non dopée intrinsèque I (208) étant formées dans ladite zone active (201).
